# EUROPEAN PATENT SPECIFICATION

(11) **EP 0 590 635 B1**
(45) Date of publication and mention of the grant of the patent: **17.07.1996**
(21) Application number: 93115712.7
(22) Date of filing: 29.09.1993
(51) Int. Cl.: C23C 18/22, H05K 3/38, H05K 3/46

(54) **A method for producing a multi-layered printed wiring board**
Verfahren zur Herstellung einer mehrschichtigen Leiterplatte
Procédé pour la fabrication d'une plaque à circuit imprimé multicouche

(30) Priority: 29.09.1992 JP 259548/92
(43) Date of publication of application: 06.04.1994
(73) Proprietor: MATSUSHITA ELECTRIC INDUSTRIAL CO., LTD., Kadoma-shi, Osaka 571 (JP)
(72) Inventor: Nakamura, Tsuneshi, Hirakata-shi, Osaka (JP)
(74) Representative: Schwabe - Sandmair - Marx

(56) References cited:
- EP-A- 0 197 323
- EP-A- 0 379 686
- EP-A- 0 478 313
- DE-A- 3 913 966
- FR-A- 2 227 109
- GB-A- 1 276 527
- GALVANOTECHNIK vol. 74, no. 3 , March 1983 , SAULGAU/WURTT DE pages 269 - 274 A.F. BOGENSCHÜTZ ET AL. 'Vergleichende Untersuchungen an verschiedenen Vorbehandlungsmethoden für unkaschierte Leiterplatten-Basismaterialien'
- DATABASE WPI Week 7747, Derwent Publications Ltd., London, GB; AN 77-83991Y & JP-A-52 123 334 (DAINI SEIKOSHA) 17 October 1977
- DATABASE WPI Week 7747, Derwent Publications Ltd., London, GB; AN 77-83991Y & JP-A-52 123 334

## Description

### Background of the Invention

### 1. Field of the Invention

The present invention relates to a method for producing a multi-layered printed wiring board used for electronic devices.

### 2. Description of the Related Art

GB-A-1,276,527 shows a fabrication process for a metal core printed circuit board wherein an anodized Al-sheet comprising through holes serves as a substrate which is coated with an insulating resin. This insulating coating surface is sandblasted with No. 220 garnet particles at a pressure of 50 - 100 pounds, cleaned, rinsed with water, chemically etched with caustic KMnO₄ or chromic acid, seeded or electroless coated with Ni and thereafter electroplated with Cu.

Further conventional production methods for a multi-layered printed wiring board are described in, for example, Japanese Laid-Open Patent Publication No. 4-148590. The Japanese Laid-Open Patent Publication No. 4-148590 discloses a production method for a multi-layered wiring board comprising the steps of forming a first circuit conductor layer by etching a copper foil provided on the top and bottom surfaces of an insulating substrate; forming an insulating resin layer having photo via holes on the first circuit conductor layer; chemically roughening the surface of the insulating resin layer after forming through-holes in the insulating substrate; and forming a second circuit conductor layer on the roughened suface of the insulating resin layer by an electroless copper plating method and an electrolytic copper plating method so as to electrically inter-connect the first and second circuit conductor layers to each other through the photo via holes and the through-holes.

In this conventional method, the chemical etching treatment mainly using potassium permangante is performed as a pretreatment for forming the electroless copper plating layer on the insulating resin layer. The chemical etching treatment has an objective to form minute irregularities on the surface of the insulating resin layer by chemical etching, thereby improving the adhesion of the electroless plating layer to the insulating resin layer.

The above-mentioned conventional technique, however, still cannot attain sufficient adhesion between the insulating resin layer and the electroless copper plating.

Further, the reliability of the electrical connection within the blind via holes and the through-holes by the electroless plating is not sufficient.

### Summary of the Invention

It is the object of the invention to provide a method for producing a multi-layered printed wiring board with highly reliable electrical connections between the circuit conductor layers.

This object is solved by the features of claim 1.

Suitable embodiments are defined by the features of the subclaims 2-16.

The invention described herein makes possible the advantages of providing an excellent adhesion between a circuit conductor layer and the underlying insulating resin layer in addition to the reliability to make the via holes and through-holes very conductive.

These and other advantages of the present invention become apparent to those skilled in the art upon reading and understanding the following detailed description with reference to the accompanying drawings.

### BRIEF DESCRIPTION OF THE DRAWINGS

Figures **1A** to **1D** are cross-sectional views showing a plating method according to the present invention.

Figure **2** shows a copy of a microphotograph of a surface of an insulating resin layer, after being subjected to the sandblasting treatment using abrasives having a grain diameter of #120 and the consequent chemical etching.

Figure **3** shows a copy of a microphotograph of the surface of an insulating resin layer, after being subjected to the sandblasting treatment using abrasives having a grain diameter of #240 and the consequent chemical etching.

Figure **4** is a copy of a microphotograph of the surface of an insulating resin layer after the sandblasting treatment using abrasives having a grain diameter of #320 and the consequent chemical etching.

Figure **5** is a copy of a microphotograph of the surface of an insulating resin layer without the sandblasting treatment.

Figure **6** shows a copy of a microphotograph of the surface of an insulating resin layer after three desmear treatments.

Figures **7A** to **7F** are cross-sectional views showing a main production process of a multi-layered printed wiring board according to the present invention.

Figures **8A** and **8B** are cross-sectional views showing the production method for a multi-layered printed wiring board having through-holes according to the present invention.

Figures **9A** and **9B** are cross-sectional views showing the production method for a multi-layered printed wiring board having a resistor film therein according to the present invention.

### DESCRIPTION OF THE PREFERRED EMBODIMENTS

The present invention will now be described by way of examples, with reference to the accompanying drawings.

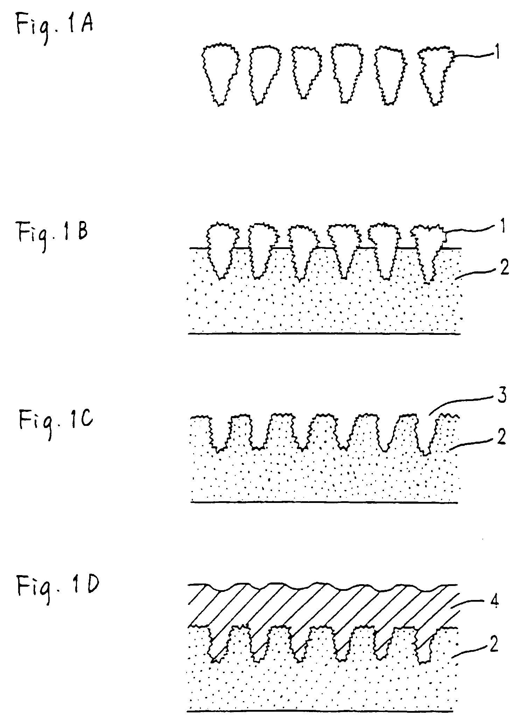

With reference to Figures **1A** to **1D**, a plating method of the present invention will be described. A plurality of spalled grain-shaped abrasives **1** having complicated shapes as is shown in Figure **1A** are used in this method. These abrasives **1** are used for a sandblasting treatment of an insulating resin layer which will be described in detail. Examples of the abrasives 1 include spalled grain-shaped alumina and silicon carbide inorganic powder both having a grain diameter in the range of #80 to #320 (ISO standard).

Next, the plurality of abrasives **1** are sprayed onto a surface of an insulating resin layer **2** by a dry spray method using compressed air. This process is referred to as a dry sandblasting treatment.

By the dry sandblasting treatment, part of the abrasives **1** are sunk into the surface of the insulating resin layer **2** as shown in Figure **1B**. Many of the abrasives **1** which have not been sunk into the insulating resin layer **2** also hit the surface and remain thereon (not shown). In a wet spraying method in which a liquid material including the abrasives is sprayed onto the insulating resin layer, the insulating resin layer is covered with the liquid material, so that the abrasives have a difficulty in sinking into the insulating resin layer. Accordingly, the wet spray method is not suitable for the present invention.

Next, both the abrasives **1** having sunk into the surface of the insulating resin layer **2** and the abrasives **1** remaining on the surface thereof are removed by a cleaning process. An air method and/or an ultrasonic cleaning method can be used for the cleaning process. Preferably, substantially all the abrasives **1** are removed from the surface of the insulating resin layer **2**. Thus, the surface of the insulating resin layer **2** becomes rough as shown in Figure **1C**. Part of the complicated shapes of the abrasives **1** are transferred onto the surface of the insulating resin layer **2**. As a result, the shape of the insulating resin layer **2** reflects the shape of the abrasives **1**. Herein, the structure formed on the surface of the insulating resin layer **2** as is shown in Figure **1C** is referred to as an "anchor structure". The roughness of the insulating resin layer **2**, i.e., the specific shape of the anchor structure, varies depending on various factors, such as the material, the shape, and the grain size of the abrasive **1**; the material of the insulating resin layer **2**; and the condition for spraying the abrasives **1**. Further, it is understood that even the abrasives **1** not having sunk into the surface of the insulating resin layer **2** contribute to the formation of the anchor structure by hitting the surface of the insulating resin layer **2**.

According to the method of the present invention, the distribution of the irregularities formed on the surface of the insulating resin layer **2** (the anchor structure) is isotropic along the surface thereof. If the surface of the insulating resin layer **2** is ground with a sandpaper or the like, a plurality of line-shaped grooves are formed in a certain direction thereon. Herein, such a structure is not included in the "anchor structure". Since the anchor structure obtained by the present method has a plurality of irregularities, the surface area of the insulating resin layer **2** is larger than that of the structure having a plurality of line-shaped grooves.

It is preferable that the insulating resin layer **2** be made from a flexible and elastic material, so that the abrasives **1** can be readily sunk into the insulating resin layer **2**. When more abrasives **1** are more deeply sunk into the insulating resin layer **2**, a more complicated anchor structure is formed thereon, resulting in a larger rough surface area. This improves the adhesion between the insulating resin layer **2** and a plating layer formed in the subsequent process. In this example, the resulting resin layer **2** is made from an ultraviolet-hardened epoxy resin mixed with approximately 20 wt% of fine powder of silicon. This material is relatively flexible and elastic, having a glass transition temperature of 117°C. When the insulating resin layer **2** made from this material is subjected to the dry sandblasting treatment, at a spray pressure of 3 to 4 kg/cm², the irregularities having a roughness Rmax of 5 to 12 µm are formed on the insulating resin layer **2**.

Next, the resulting insulating resin layer **2** having the rough surface is dipped into a chromic acid-sulfuric acid type solution or a powerful oxidizing solution including potassium permanganate or the like. In this manner, part of the surface of the insulating resin layer **2** made from the epoxy resin are chemically etched. Such a chemical etching provides irregularities having a smaller roughness than that of the irregularities obtained by the dry sandblasting treatment. As a result, the surface area of the insulating resin layer **2** becomes larger and the adhesion is further increased.

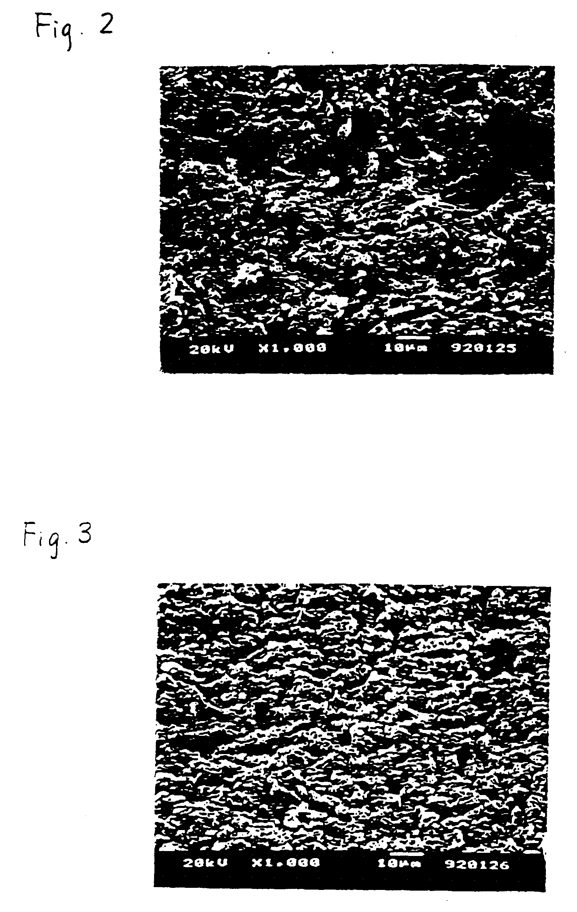

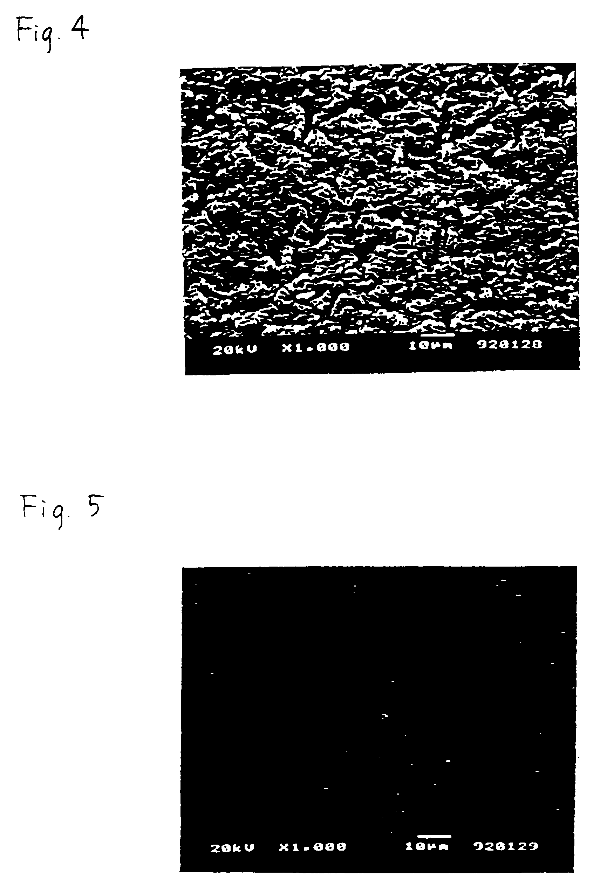

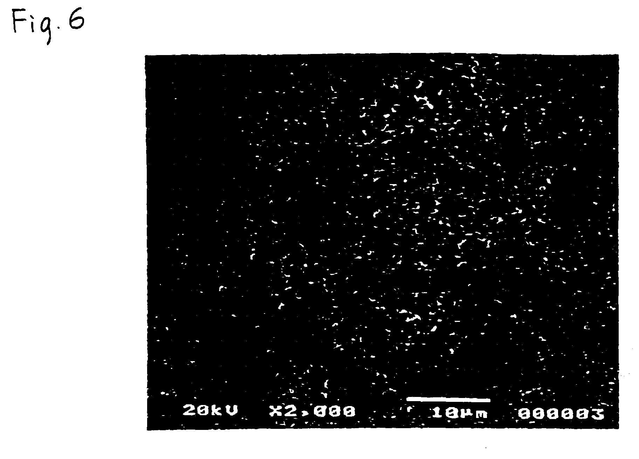

Figures **2** to **4** are copies of microphotographs of the surfaces of insulating resin layers, after the dry sandblasting treatment and the chemical etching. In more detail, Figures **2**, **3** and **4** show the insulating resin layers subjected to the dry sandblasting treatments using abrasives having the grain diameters of #120, #240, and #320, respectively. In addition, Figure **5** is a copy of a microphotograph of an insulating resin layer with no dry sandblasting treatment, and Figure **6** is a copy of a microphotograph of an insulating resin layer subjected to three desmear treatments. As can be seen from these microphotographs, irregularities of the insulating resin layer (the anchor structure) can be made more complicated by the chemical etching followed by the dry sandblasting treatment than those obtained without the dry sandblasting treatment or by the desmear treatment.

Next, the resulting insulating resin layer **2** is dipped into a hydrochloric acidic solution including tin chloride and palladium chloride so as to be activated. By this activating treatment, fine particles of metal palladium (not shown), which are to be used as catalyst cores for the electroless plating, are absorbed up on the surface of the insulating resin layer **2**. The insulating resin layer **2** is then dipped into an electroless copper plating solution including formalin and an alkalic solution of copper complex salt. Thus, metal copper is grown to be a thin layer having a thickness of approximately of 1 µm by the electroless copper plating and then by the electrolytic copper plating, the resulting metal copper is regrown to have a desired thickness. In this manner, a conductive metal layer **4** is formed on the insulating resin layer **2** as shown in Figure **1D**.

Table 1 described below shows roughness of the surface of an insulating resin layer and the peeling strength of the conductive metal layer obtained by an abrasive each having the listed grain size. As is shown in Table 1, a higher peeling strength can be achieved by the plating method of the present invention than those attained by the conventional method.

**Table 1:**

| Relationship between Roughness of Surface and Peeling Strength | | |
|---|---|---|
| Grain Diameter of Abrasives | Roughness of Surface | Peeling Strength |
| #80 | Rmax 12 µm | 1.8 kg/cm |
| #120 | Rmax 10 µm | 1.5 kg/cm |
| #180 | Rmax 8 µm | 1.4 kg/cm |
| #240 | Rmax 6 µm | 1.2 kg/cm |
| #320 | Rmax 5 µm | 1.0 kg/cm |
| conventional example | _________ | 0.8 kg/cm |

The adhesion (i.e., the peeling strength) of the conductive metal layer **4** (i.e., the plating layer) to the insulating resin layer **2** is improved by the plating method of the present invention, mainly because the complicated anchor structure can be formed on the surface of the insulating resin layer **2** as shown in Figures **1C** and **2** to **4**. Another reason is as follows: A surface resin component of the inner wall of the recess **3** shown in Figure **1C** is selectively etched by the chemical etching. As a result, the fine powder of silica included in the insulating resin layer **2** can appear as microscopic projections on the insulating resin layer **2,** because silica is unlikely to be etched under the condition of the chemical etching. These microscopic projections are sunk into the surface of the conductive metal layer **4,** thereby further improving the adhesion.

The surface of the insulating resin layer **2** roughened by the dry sandblasting treatment is in an extremely activated state, thereby improving the absorption of palladium into the insulating resin layer **2** in the above-mentioned activating treatment. As a result, in the electroless copper plating, metal copper is more uniformly deposited on the insulating resin layer **2,** thereby improving the adhesion of the conductive metal layer **4** to the insulating resin layer **2**.

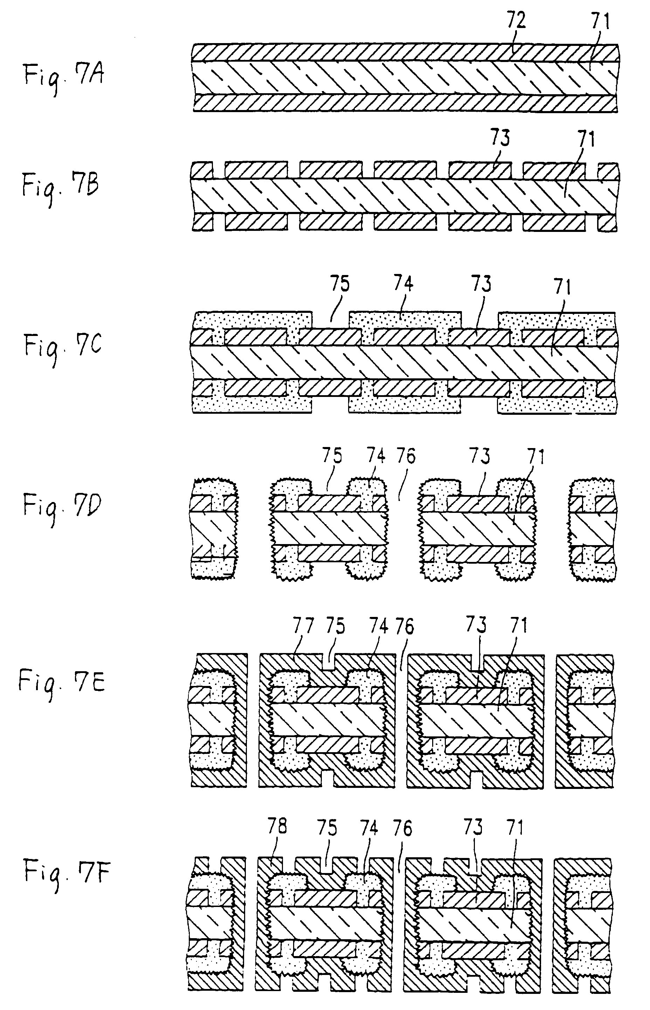

The production method for a multi-layered printed wiring board according to the present invention will now be described below with reference to Figures **7A** to **7F**. In this example, the production process for a multi-layered printed wiring board having a four-layered circuit conductor layer will be described.

As is shown in Figure **7A,** so-called a copper-clad laminated substrate comprising an insulating substrate **71** such as a glass epoxy laminated board bearing a copper foil **72** with a thickness of 28,35 g (1 ounce) or 14,175 g (a half ounce) on each surface is used in this example. Unnecessary portions of the copper foil **72** is selectively etched by a known technique such as the photoetching. Thus, a first circuit conductor layer **73** having a desired pattern is formed on each surface of the insulating substrate **71** as is shown in Figure **7B**.

Next, an insulating resin layer **74** is applied on each surface of the insulating substrate **71** so as to cover the first circuit conductor layer **73**. The insulating resin layer **74** is required to be a resin layer having excellent characteristics, such as electrical insulation, heat resistance, and chemical resistance. In this example, an insulating paste, obtained by mixing an ultraviolet-hardened epoxy resin with inorganic powder, such as alumina and silica, and then adjusting the viscosity thereof, is used as the insulating resin layer **74**. The insulating paste having a thickness of 80 to 120 µm is formed by a screen printing method or a curtain coating method. The above-mentioned objective is thus achieved.

After drying the insulating resin layer **74**, a mask film is attached thereto. The resulting insulating resin layer **74** is irradiated with UV rays through the mask film. The mask film has a pattern for defining positions and shapes of via holes **75**. Next, unirradiated portions of the insulating resin layer **74** are selectively etched by a developing treatment. Thus, the via holes **75** are formed at desired positions of the insulating resin layers **74** as is shown in Figure **7C**. After that, the insulating resin layers **74** are heated at 150°C for 60 minutes for further hardening.

There is another method for forming the via holes **75** as follows: the insulating resin layer **74** is covered with a thermosetting epoxy resin having high heat resistance mixed with an inorganic filler. Then, the via holes **75** are formed at the desired positions of the resulting insulating resin layer **74** by YAG laser or eximer laser.

Next, as is shown in Figure **7D**, through-holes **76** are formed at desired positions of the insulating substrate **71** by drilling, and then the insulating substrate **71** is subjected to the dry sandblasting treatment and the chemical etching. These surface treatments are performed in the same way as the treatment described referring to Figures **1A** to **1D** as follows: powder such as alumina and silica having a complicated shape is used as the dry sandblasting abrasive and is sprayed onto the insulating resin layer **74** at the pressure of 3 to 4 kg/cm² by the dry spray. As a result, the insulating resin layer **74** has a rough and complicated-shaped surface. Then, the insulating resin layer **74** is etched in a potassium permanganate solution to form the anchor structure having a microscopic rough surface on the insulating resin layer **74**. The surface of the insulating resin layer **74**, the inner walls of the via holes **75** and the through-holes **76** are roughened by a series of surface treatments.

As a result of the evaluation of the electrical insulation characteristics and the adhesion of the electroless copper planting, the following has been founded: it is preferable that the roughness Rmax of the surface is adjusted in the range of 5 to 12 µm by the dry sandblasting treatment because this is the optimal condition to improve the conductor adhering strength by the electroless copper plating without degrading the electrical insulation characteristics.

Next, the insulating substrate **71** having the rough surface is dipped into an activating solution including a hydrochloric acidic chloride solution of stannous chloride and palladium chloride so as to attach the catalyst cores made from fine particles of metal palladium thereto. Then, a conductive metal layer **77** made from metal copper is formed on the entire surface of the insulating resin layer **74** including the through-holes **76** by the electroless copper planting, and a conductive metal layer is further formed thereon by electrolytic copper plating, if necessary. Thus, the structure shown in Figure **7E** is obtained.

Next, unnecessary portions of the conductive metal layer **77** are selectively etched by a known method such as photoetching, thereby forming a second circuit conductor layer **78** on the insulating resin layer **74**. Thus, as is shown in Figure **7F,** the multi-layered printed wiring board having the four-layered structure in which the first and second circuit conductor layers **73** and **78** are electrically connected to each other through the via holes **75** and the through-holes **76** is obtained. The first and second circuit conductor layer **73** and **78** work as an inner circuit conductor layer and the outer circuit conductor layer, respectively.

In this example, the surface of the insulating resin layer **74** in the multi-layered printed wiring board is roughened by both a mechanical method using the dry sandblasting treatment and the wet chemical etching using an oxidant. Thus, minute irregularities having a complicated shape and high density are formed on the insulating resin layer **74**, thereby obtaining an excellent anchor structure. According to this example, the adhesion of the electroless copper plating can be improved. Further, at the corners of the through-holes **76** and the via holes **75**, appropriate tapers can be formed. Further, the exposed surface of the first circuit conductor layer **73** and the inner wall of the through-holes **76** can be cleaned. As a result, the adhesion and the throwing power of electrolytic coloring of the electroless copper plating are significantly improved, thereby providing a multi-layered printed wiring board having an excellent reliability in the electrical connection between the circuit conductor layers.

In this example, the production method for the multi-layered printed wiring board having the four-layered structure is described. However, a printed wiring board having more layers can also be obtained by the repetition of the above-mentioned procedures.

In this example, a synthetic resin layer substrate such as a glass epoxy laminated board is used for the insulating substrate **71**. However, the method for the insulating substrate is not limited to this, but ceramic such as alumina and insulated metal such as alumina, copper, iron and stainless can be used. When these materials are used, the first circuit conductor layer **73** can be formed as follows instead of adhering a copper foil on the insulating substrate. An insulating substrate is coated with an adhesive, and a conductive metal layer is directly formed thereon by the electroless copper plating or electrolytic copper plating. Then, the circuit conductor layer is formed by a known technique such as the photoetching.

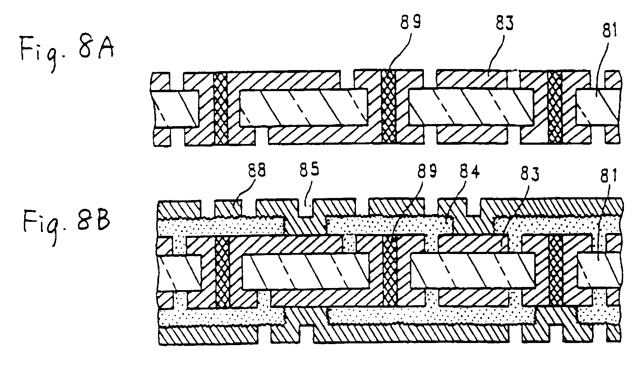

Figures **8A** and **8B** show a second example of the present invention. This example relates to production methods for a through-hole wiring board and a high-density multi-layered printed wiring board using the through-hole wiring board as a core substrate. In the through-hole wiring substrate, through-holes are filled with a filler.

In Figure **8A**, a metal copper foil is adhered to each substrate of an insulating substrate **81** made from a glass epoxy laminated plate, and etched to form a circuit conductor layer **83** as an inner layer. After forming through-holes **86** penetrating the circuit conductive layer **83**, the inner wall of the through-hole **86** is made conductive by through-hole plating. Then, the through-holes **86** are filled with a filler **89**. The wiring substrate of this example is thus fabricated.

An ultraviolet-hardened or thermosetting epoxy resin or acrylic resin is used as the filler **89**. Further, paste including insulating inorganic powder such as alumina and silica or paste including conductive powder such as copper and silver can be mixed in the filler **89**. In this case, the pastes are filled in the conductive through-holes **86** by the screen printing or the like. Further, conductor layers for connection are formed on the top and bottom surfaces of the filler **89**, if necessary.

An insulating layer **84** and via holes **85** are formed at desired positions in the same way as in the first example. Then, the surface of the insulating resin layer **84** is roughened by both the dry sandblasting method and the chemical etching using potassium permanganate. A conductive metal layer is formed thereon by the electroless plating and the electrolytic plating. Finally, a circuit conductor layer **88** is formed as the outmost layer on the resulting substrate by the photoetching. The above-mentioned layers and via holes are formed on the top and bottom surfaces of the through-hole wiring substrate, resulting in the multi-layered printed wiring board as shown in Figure **8B**.

Since the through-hole is not exposed in this multi-layered printed wiring plate, the wiring pattern on the outmost layer is designed more freely, thereby obtaining a multi-layered wiring board having a high density.

In this example, the through-hole wiring substrate is used as the core substrate, however, the core substrate is not limited to this. The core substrate can be a multi-layered wiring board whose conductive through-holes are filled and which has optional numbers of circuit conductor layers as the inner layer comprising a pre-preg insulating sheet and a copper foil.

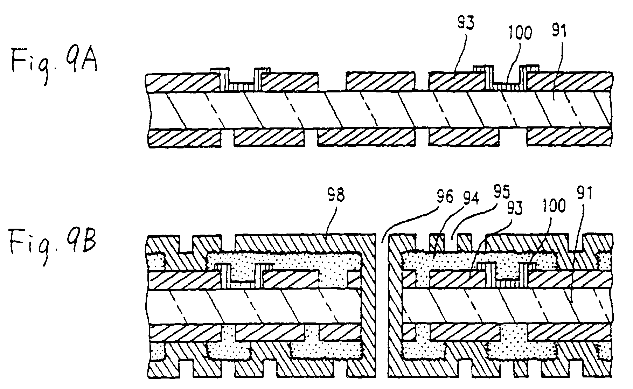

A third example of the present invention will be described with reference to Figures **9A** and **9B**.

A first circuit conductor layer **93** is formed on each surface of an insulating substrate **91** in the above-mentioned manner. Then, resistor film **100** is formed on at least one of the surfaces of the insulating substrate **91** to form a resistance-forming substrate (the core substrate) as shown in Figure **9A**. The resistor film **100** is formed as follows: the insulating substrate **91** is coated with a carbon resin resistor paste by the screen printing, and hardened with heat. Then, the shape of the resistor film **100** is adjusted by laser trimming and the resistance value of the resistor film **100** is adjusted. Alternatively, metal resistor film can be formed as the resistor film **100** by the electroless plating method.

Next, the procedures as shown in Figures **7A** to **7F** are performed, using the core substrate shown in Figure **9A**. More specifically, an insulating resin layer **94** is coated on each surface of the core substrate, and then via holes **95** and through-holes **96** are formed in the core substrate. Then, the surface of the insulating resin layer **94** and the inner walls of the via hole **95** and the through-hole **96** are appropriately roughened by the dry sandblasting treatment and the chemical etching using a potassium permanganate solution. Then, a conductive metal layer is formed on the entire surface of the substrate by the electroless copper plating and the electrolytic copper plating. A second circuit conductor layer **98** is then formed by a known technique such as the photoetching. Thus, the multi-layered printed wiring board having the substrate as shown in Figure **9B** can be fabricated.

According to the method of the present invention, the dry sandblasting treatment for spraying abrasives onto an insulating resin layer and the chemical etching for chemically etching the resulting surface are performed before plating a conductive layer. Due to both the dry sandblasting treatment and the chemical etching, a complicated shape of the abrasive is transferred on the surface of the insulating resin layer, resulting in a great increase in the surface area. Further, due to the dry sandblasting treatment, the shapes of the via holes formed at the insulating resin layer are improved, thereby cleaning the exposed surface of the circuit conductor layer and the inner walls of the through-holes.

According to the method of the present invention, a surface of an insulating resin layer is mechanically roughened by the dry sandblasting treatment, and subjected to the chemical etching. Due to this, at least the following advantages can be obtained.
(1) A minute anchor structure is formed on the insulating resin layer, so that the adhesion between the insulating layer and a plating layer (i.e., a circuit conductor layer) formed thereon can be improved.
(2) Due to the dry sandblasting treatment, the shapes of the via holes formed in the insulating layer are improved and also an exposed surface of the circuit conductor layer and the inner walls of the through-holes are cleaned. Accordingly, the electrical connection between the circuit conductor layers by the electroless copper plating becomes stable, thereby obtaining the reliability of excellent electrical characteristics.

## Claims

1. A method for producing a multi-layered printed wiring board, comprising the steps of:
forming a multi-layered wiring board by forming at least one inner circuit conductor layer on a top and bottom surface of a substrate;
forming an insulating resin layer to cover the top and bottom surfaces of the multi-layered wiring board; forming via holes in the insulating resin layer at desired positions on the multi-layered wiring board;
spraying abrasives at least onto a surface of the insulating resin layer and the inner faces of the via holes to perform a dry sandblasting treatment, and to form tapers at corners of the via holes;
chemically etching the surface of the insulating resin layer;
plating a conductive layer on the surface of the insulating resin layer and on the inner faces of the via holes; and
patterning the conductive layer into a desired pattern.

2. A method according to claim 1, further comprising the step of forming through holes in the multi-layered wiring board at desired positions on the multi-layered wiring board after forming the insulating resin layer, but before dry sandblasting the insulating resin layer.

3. A method according to claim 1, further comprising the steps of:
forming through holes penetrating the inner conductor layer and the substrate;
electrically connecting the inner circuit conductor layer formed on the top surface of the substrate and the inner ciruit conductor layer formed on the bottom surface of the substrate through the through holes; and
filling the through holes with a resin.

4. A method according to claim 1, wherein the inner faces of the via holes include faces of the insulating resin layer and exposed surfaces of the first circuit conductor layer, the exposed sufaces of the first circuit conductor layer being roughened and cleaned by the dry sandblasting treatment.

5. A method according to claim 1, wherein the dry sandblasting treatment comprises a step of spraying aluminum abrasives onto the surface of the insulating resin layer and the inner faces of the through holes by the dry spraying method.

6. A method according to claim 1, wherein the dry sandblasting treatment comprises a step of spraying abrasives of silicon carbide onto the surface of the insulating resin layer and the inner faces of the through holes by the dry spraying method.

7. A method according to claim 1, wherein a cleaning step of removing the abrasives from the surface of the insulating resin layer is performed between the dry sandblasting treatment and the chemical etching.

8. A method according to claim 7, wherein the cleaning step comprises an ultrasonic cleaning step.

9. A method according to claim 1, wherein a step of making catalyst particles used for the plating step adsorb on the surface of the insulating resin layer is performed after the chemical etching.

10. A method according to claim 1, wherein the step of forming the multi-layered wiring board comprises a step of alternately repeating the formation of the inner circuit conductor layer and the formation of an insulating layer to cover the inner circuit conductor layer.

11. A method according to claim 1, wherein the step of forming the inner conductor layer comprises a step of forming a resistance factor formed of a resistor film to be electrically connected to the circuit conductor layer.

12. A method according to claim 1, wherein the sandblasting treatment is a step of forming irregularities having roughness in the range of 5 to 12 µm on the surface of the insulating resin layer.

13. A method according to claim 3, wherein the resin used for filling the through-holes is made from an insulating resin.

14. A method according to claim 3, wherein the resin used for filling the through-holes is made from a conductive resin.

15. A method according to claim 1, wherein the insulating resin layer is formed of a material including resin mixed with fine powder of silica.

16. A method according to claim 1, wherein the insulating resin layer is formed of a material including an ultraviolet-hardened resin layer or a thermosetting resin mixed with fine powder of silica.

## Patentansprüche

1. Verfahren zur Herstellung einer mehrschichtigen Leiterplatte mit den folgenden Schritten:
Ausbilden einer mehrschichtigen Leiterplatte durch das Ausbilden mindestens einer inneren Schaltungsleiterschicht auf der oberen und der unteren Oberfläche eines Substrats;
Ausbilden einer isolierenden Harzschicht, um die obere und die untere Oberfläche der mehrschichtigen Leiterplatte abzudecken;
Ausbilden von Durchführungslöchern in der isolierenden Harzschicht an gewünschten Positionen auf der mehrschichtigen Leiterplatte;
Aufstrahlen von Strahlmitteln auf zumindest eine Oberfläche der isolierenden Harzschicht und die Innenflächen der Durchführungslöcher, um eine Trocken-Sandstrahlbehandlung durchzuführen und um (konische) Übergänge an den Ecken der Durchführungslöcher auszubilden;
chemisches Ätzen der Oberfläche der isolierenden Harzschicht;
Platieren einer leitenden Schicht auf die Oberfläche der isolierenden Harzschicht und auf die inneren Oberflächen der Durchführungslöcher; und
Ausbildung der leitenden Schicht zu einem gewünschten Muster.

2. Verfahren gemäß Anspruch 1, das weiterhin den Schritt des Ausbildens von Durchgangslöchern in der mehrschichtigen Leiterplatte an gewünschten Positionen der mehrschichtigen Leiterplatte nach dem Ausbilden der isolierenden Harzschicht, aber vor dem Trocken-Sandstrahlen der isolierenden Harzschicht umfaßt.

3. Verfahren gemäß Anspruch 1, das ferner die folgenden Schritte aufweist:
Ausbildung von Durchgangslöchern, die die innere Leiterschicht und das Substrat durchdringen;
elektrisches Verbinden der inneren Schaltungsleiterschicht, die auf der oberen Oberfläche des Substrats ausgebildet ist, und der inneren Schaltungsleiterschicht, die auf der unteren Oberfläche des Substrats ausgebildet ist, durch die Durchgangslöcher; und
Füllen der Durchgangslöcher mit Harz.

4. Verfahren gemäß Anspruch 1, bei dem die inneren Flächen der Durchführungslöcher Flächen der isolierenden Harzschicht und freiliegende Oberflächen der ersten Schaltungsleiterschicht umfassen, wobei die freiliegenden Oberflächen der ersten Schaltungsleiterschicht durch die Trocken-Sandstrahlbehandlung aufgerauht und gereinigt werden.

5. Verfahren nach Anspruch 1, bei dem die Trocken-Sandstrahlbehandlung den Schritt des Aufstrahlens von Aluminium-Strahlmitteln auf die Oberfläche der isolierenden Harzschicht und die inneren Flächen der Durchgangslöcher durch das Trockenstrahlverfahren umfaßt.

6. Verfahren gemäß Anspruch 1, bei dem die Trocken-Sandstrahlbehandlung den Schritt des Aufstrahlens von Siliconcarbid auf die Oberfläche der isolierenden Harzschicht und die Innenflächen der Durchgangslöcher durch das Trockenstrahlverfahren umfaßt.

7. Verfahren gemäß Anspruch 1, bei dem der Reinigungsschritt des Entfernens der Strahlmittel von der Oberfläche der isolierenden Harzschicht zwischen der Trocken-Sandstrahlbehandlung und dem chemischen Ätzen durchgeführt wird.

8. Verfahren gemäß Anspruch 7, bei dem der Reinigungsschritt einen Ultraschall-Reinigungsschritt umfaßt.

9. Verfahren nach Anspruch 1, bei dem nach dem chemischen Ätzen ein Schritt durchgeführt wird, bei welchem Katalysatorteilchen, die für den Platierungsschritt verwendet werden, auf der Oberfläche der isolierenden Harzschicht adsorbiert werden.

10. Verfahren gemäß Anspruch 1, bei dem der Schritt des Ausbildens der mehrschichtigen Leiterplatte einen Schritt des wechselweisen Wiederholens der Ausbildung der inneren Schaltungsleiterschicht und der Ausbildung der isolierenden Schicht zum Abdecken der inneren Schaltungsleiterschicht umfaßt.

11. Verfahren gemäß Anspruch 1, bei dem der Schritt des Ausbildens der inneren Leiterschicht einen Schritt des Ausbildens eines Widerstandsfaktors umfaßt, der aus einem Widerstandsfilm gebildet wird, welcher elektrisch mit der Schaltungsleiterschicht zu verbinden ist.

12. Verfahren gemäß Anspruch 1, bei dem die Sandstrahlbehandlung ein Schritt des Ausbildens von Unregelmäßigkeiten mit einer Rauhigkeit im Bereich von 5 bis 12 µm auf der Oberfläche der isolierenden Harzschicht ist.

13. Verfahren gemäß Anspruch 3, bei dem das für das Füllen der Durchgangslöcher verwendete Harz aus einem isolierenden Harz hergestellt ist.

14. Verfahren gemäß Anspruch 3, bei dem das zum Füllen der Durchgangslöcher verwendete Harz aus einem leitenden Harz hergestellt ist.

15. Verfahren gemäß Anspruch 1, bei dem die isolierende Harzschicht aus einem Material ausgebildet ist, das Harz, gemischt mit feinem Siliziumoxidpulver, umfaßt.

16. Verfahren gemäß Anspruch 1, bei dem die isolierende Harzschicht aus einem Material ausgebildet ist, das eine ultraviolett aushärtende Harzschicht oder ein wärmeaushärtendes Harz, gemischt mit einem feinen Siliziumoxidpulver, umfaßt.

## Revendications

1. Procédé de production d'une carte imprimée de câblage multicouche qui comprend les étapes consistant à:
réaliser une carte de câblage multicouche en réalisant au moins une couche conductrice de circuit intérieur sur la surface supérieure et la surface inférieure d'un substrat;
réaliser une couche de résine isolante pour couvrir les surfaces supérieure et inférieure de la carte de câblage multicouche;
réaliser des trous traversants dans la couche de résine isolante à des positions voulues sur la carte de câblage multicouche;
pulvériser des abrasifs au moins sur une surface de la couche de résine isolante et les faces intérieures des trous traversants afin de réaliser un traitement de sablage à sec, et de réaliser des évasements aux coins des trous traversants;
graver chimiquement la surface de la couche de résine isolante;
plaquer une couche conductrice sur la surface de la couche de résine isolante et sur les faces intérieures des trous traversants; et
dessiner sur la couche conductrice selon le dessin souhaité.

2. Procédé selon la revendication 1, comprenant en outre l'étape consistant à réaliser des trous traversants dans la carte de câblage multicouche à des positions voulues sur la carte de câblage multicouche après réalisation de la couche de résine isolante, mais avant le sablage à sec de la couche de résine isolante.

3. Procédé selon la revendication 1 comprenant en outre les étapes consistant à:
réaliser des trous traversants qui pénètrent à travers la couche conductrice intérieure et le substrat;
connecter électriquement au moyen des trous traversants la couche conductrice de circuit intérieur réalisée sur la surface supérieure du substrat et la couche conductrice du circuit intérieur réalisée sur la surface inférieure du substrat; et
remplir d'une résine les trous traversants.

4. Procédé selon la revendication 1, dans lequel les faces intérieures des trous traversants incluent des faces de la couche de résine isolante et des surfaces exposées de la première couche conductrice de circuit, les surfaces exposées de la première couche conductrice de circuit étant rendues rugueuses et nettoyées par le traitement de sablage à sec.

5. Procédé selon la revendication 1, dans lequel le traitement de sablage à sec comprend une étape de pulvérisation d'abrasifs d'aluminium sur la surface de la couche de résine isolante et les faces intérieures des trous traversants, par le procédé de pulvérisation à sec.

6. Procédé selon la revendication 1, dans lequel le traitement de sablage à sec comprend une étape de pulvérisation d'abrasifs de carbure de silicium sur la surface de la couche de résine isolante et les faces intérieures des trous traversants, par le procédé de pulvérisation à sec.

7. Procédé selon la revendication 1, dans lequel l'étape de nettoyage consistant à enlever les abrasifs de la surface de la couche de résine isolante est effectuée avant le traitement de sablage à sec et la gravure chimique.

8. Procédé selon la revendication 1, dans lequel l'étape de nettoyage comprend une étape de nettoyage ultrasonique.

9. Procédé selon la revendication 1, dans lequel une étape consistant à amener des particules de catalyseur, utilisées pour l'étape de placage, à être adsorbées sur la surface de la couche de résine isolante, est effectuée après la gravure chimique.

10. Procédé selon la revendication 1, dans lequel l'étape de réalisation de la carte de câblage multicouche comprend une étape consistant à répéter de façon alternée la réalisation de la couche conductrice de circuit intérieur et la réalisation d'une couche isolante, de façon à couvrir la couche conductrice de circuit intérieur.

11. Procédé selon la revendication 1, dans lequel l'étape de réalisation de la couche conductrice intérieure comprend une étape de réalisation d'un facteur de résistance réalisé sur un film résistant de manière à être connecté électriquement à la couche conductrice de circuit.

12. Procédé selon la revendication 1, dans lequel le traitement de sablage est une étape consistant à réaliser, sur la surface de la couche de résine isolante, des irrégularités dont la rugosité est dans la plage de 5 à 12 µm.

13. Procédé selon la revendication 3, dans lequel la résine utilisée pour remplir les trous traversants consiste en une résine isolante.

14. Procédé selon la revendication 3, dans lequel la résine utilisée pour remplir les trous traversants consiste en une résine conductrice.

15. Procédé selon la revendication 1, dans lequel la couche de résine isolante consiste en une matière qui inclut une résine mélangée avec une fine poudre de silice.

16. Procédé selon la revendication 1, dans lequel la couche de résine isolante consiste en une matière qui inclut un couche de résine durcie aux ultraviolets ou une couche de résine thermodurcissable mélangée avec une fine poudre de silice.
